Europäisches Patentamt

European Patent Office

Office européen des brevets

(19)

(11) Numéro de publication: **0 214 024 B1**

## FASCICULE DE BREVET EUROPEEN

(12)

(45) Date de publication de fascicule du brevet:
02.10.91

(51) Int. Cl.⁵: **C03C 17/34, C23C 16/02**

(21) Numéro de dépôt: 86401746.2

(22) Date de dépôt: 05.08.86

(54) **Couche d'oxyde d'étain, procédé de dépôt et substrat ainsi revêtu.**

(30) Priorité: 05.08.85 JP 172125/85

(43) Date de publication de la demande:
11.03.87 Bulletin 87/11

(45) Mention de la délivrance du brevet:
02.10.91 Bulletin 91/40

(84) Etats contractants désignés:
AT BE CH DE FR GB IT LI LU NL SE

(56) Documents cités:
EP-A- 0 114 282
FR-A- 2 439 165
GB-A- 2 131 792

(73) Titulaire: **SAINT-GOBAIN VITRAGE INTERNATIONAL**
**18, avenue d'Alsace**
**F-92400 Courbevoie(FR)**

(72) Inventeur: **Katoh, Yukihiro**
**2-1-403 Nigawa-cho 2-chome**
**Nischinomiyashi Hyogo(JP)**
Inventeur: **Kawahara, Hideo**
**8-3-205 Minami Sakurazuka 2-chome**
**Toyonaka-shi Osaka(JP)**
Inventeur: **Hyodoh, Masato**
**21, Nakano-Higashi 3-chome**
**Itami-shi Hyogo(JP)**
Inventeur: **Yamamoto, Hironobu**
**6-3-6 Sagamihara**
**Sagamihara-shi Kanagawa(JP)**

(74) Mandataire: **Leconte, Jean-Gérard et al**
**Saint-Gobain Recherche 39, Quai Lucien Lefranc**
**F-93304 Aubervilliers Cedex(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention concerne une couche mince d'oxyde d'étain à propriétés améliorées déposée sur la surface d'un substrat de verre. Plus précisément, elle porte sur l'amélioration de la technique de dépôt d'une couche d'oxyde d'étain consistant à chauffer le substrat en verre à une haute température et à déposer une couche d'oxyde d'étain sur la surface de ce substrat par la mise en contact avec cette surface, d'un composé d'étain décomposable à la chaleur.

En général, étant donné que la couche d'oxyde d'étain déposée sur la surface du substrat de verre est très dure, elle est utilisée largement pour éviter l'endommagement de la surface des bouteilles, vaisselles, ampoules, plaques de verre, etc...

Il existe de nombreuses applications des couches d'oxyde d'étain dopées à l'antimoine ou avec un halogène tel que le fluor, utilisant le caractère métallique de ces couches. Par exemple, des verres revêtus d'une couche d'oxyde d'étain sont utilisés comme électrodes transparentes pour des dispositifs semi-conducteurs tel que cellules à cristaux liquides, piles solaires, etc...

De plus, ils sont également utilisés comme éléments chauffants dans des verres anti-buée, etc...

En profitant de l'excellent caractère réflecteur des rayons infra-rouges de la couche d'oxyde d'étain, on réalise des verres couvrant des collecteurs de la chaleur solaire et des vitres à caractère d'isolation renforcée ayant pour but d'améliorer l'efficacité du chauffage.

Pour déposer une couche d'oxyde d'étain sur la surface d'un substrat en verre, il existe plusieurs méthodes. Mais, comme méthodes appropriées pour la fabrication en série, on utilise des méthodes basées sur la décomposition et l'oxydation thermique d'un composé d'étain.

Depuis longtemps, on utilise la méthode consistant à pulvériser une solution de tétrachlorure d'étain dans un solvant sur la surface d'un substrat en verre porté à une haute température (méthode de pulvérisation de liquide) et l'autre méthode consistant à projeter sur la surface d'un substrat en verre, un gaz comprenant une poudre fine de composé organique d'étain (méthode de projection de poudre). Et, depuis, quelques années, on utilise largement la méthode CVD consistant à mettre la surface d'un substrat de verre en contact avec la vapeur obtenue par la vaporisation d'un composé, par exemple : du tétrachlorure d'étain ou du diméthyldichlorure d'étain.

Concernant les couches d'oxyde d'étain déposées selon ces méthodes, des applications demandant une haute conductivité électrique et une haute transmissibilité de la lumière se sont développées très rapidement ces dernières années. Pour cela, afin d'obtenir des couches d'oxyde d'étain d'une haute conductivité, il a été proposé, par exemple : en CVD d'employer comme matière première, un composé d'étain, par exemple : du tétraméthyl étain, auquel on mélange un adjuvant, par exemple : du bromotrifluo-rométhane ($CF_3Br$) (demande de brevet JP mise à la disposition du public sous le n° 55-58363).

Il a également été proposé de déposer une couche d'oxyde d'étain d'une haute conductivité selon la méthode CVD consistant à utiliser un mélange de vapeur de monobutyl trichlorure d'étain ($C_4H_9SnCl_3$) et de fluorure ayant une structure $CF_2HX$ (X : hydrogène, halogène ou groupe alkyle) (demande de brevet européen 121 459).

De plus, afin d'obtenir une couche d'oxyde d'étain très conductrice, il existe une méthode consistant à utiliser comme substrat, un verre au silicate de bore ou de quartz à la place du verre à base de soude et de chaux ou à revêtir la surface d'un verre silico-sodo-calcique, d'une couche d'oxyde de silicium avant de déposer une couche d'oxyde d'étain. Mais cela implique une limitation dans le substrat ou un traitement d'un autre type des substrats en verre classique.

Les couches obtenues selon ces méthodes, ont des conductivités maximales de 3000 $Ohm.^{-1}cm^{-1}$, c'est-à-dire des résistivités de 3.3 x $10^{-4}$ Ohm.cm.

Les couches ont donc des performances électriques inférieures à celles des couches d'oxyde d'indium dopé à l'étain.

Par le document EP-A-114 282, il est connu de déposer des couches d'oxyde d'indium dopé à l'étain (ITO) sur un support de verre par immersion du support dans une solution de composés hydrolysables de l'étain et de l'indium. En vue d'obtenir, par ce procédé, des couches d'ITO ayant des propriétés notamment de conductivité et de transmission de la lumière analogues à celles des couches d'ITO obtenues par d'autres procédés, par exemple sous vide, et en outre ayant des propriétés de résistance mécanique et de durabilité chimique, le support de verre est recouvert, avant le dépôt de la couche d'ITO, d'une couche formée d'un mélange d'oxyde de silicium ($SiO_2$) et d'oxyde de tantale, de zirconium de titane, d'aluminium ou d'étain.

Il est aussi connu, par le document FR-A-2 439 165, de former, sur un support de verre, une précouche d'oxyde de titane, de nickel ou de zinc par pyrolyse, puis de former une couche d'oxyde d'étain par pyrolyse en phase vapeur, la précouche servant à déterminer le voile due à la diffusion de la lumière.

La présente invention vise à fournir des couches hautement conductrices à base d'oxyde d'étain. Elle propose pour cela un traitement préalable du même type que le revêtement définitif, consistant à mettre la surface du substrat en verre en contact avec une solution de chlorures d'éléments du groupe IV, à savoir, une solution de tétrachlorure de titane ($TiCl_4$), de tétrachlorure de Zirconium ($ZrCl_4$) ou de tétrachlorure d'hafnium ($HfCl_4$) ou bien un mélange de ceux-ci (désignée ci-après "solution de traitement"), à déposer une couche de la composition principalement composée du chlorure du groupe IV, et à former ensuite par pyrolyse, une couche d'oxyde d'étain sur la surface du substrat ainsi préalablement traitée.

Selon une forme préférée de l'invention, les chlorures du groupe IVa sont dissous de façon que leur concentration soit de 0,1 à 10,0 % en poids, de préférence, de 0,3 à 3,0 % en poids. Comme solvants, on peut utiliser l'eau, le méthanol, l'éthanol, l'isopropanol, le butanol, le toluène, le méthyl éthylcétone, etc... ou des mélanges de ces solvants. Pour mettre la surface du substrat de verre en contact avec une solution ainsi obtenue et pour déposer une couche de la composition principalement composée de chlorures du groupe IV, il existe plusieurs méthodes.

Selon une première méthode, le substrat en verre est immergé et trempé dans la solution de traitement puis enlevé immédiatement de cette solution. La surface du substrat est mouillée. Ensuite, on évapore le solvant de cette solution de traitement adhérant sur la surface du substrat et on obtient une couche de la composition principalement composée de chlorures du groupe IV sur cette surface de substrat.

Selon une seconde méthode, la solution de traitement est déposée seulement sur une partie de la surface du substrat en verre, celle dans laquelle on souhaite obtenir une couche d'oxyde très conductrice. Alors, cette partie de la surface du substrat est mouillée avec la solution de traitement, et une couche de la composition principalement composée de chlorures du groupe IV est formée sur la surface du substrat par évaporation du solvant de la solution ayant adhéré sur cette surface.

Selon une troisième méthode, la solution de traitement est pulvérisée sur la surface du substrat chauffé de 30 à 600°C, de préférence, de 50 à 200°C ; le solvant de la solution de traitement pulvérisée qui a atteint la surface du substrat est alors évaporé immédiatement. Une couche de la composition principalement composée de chlorures du groupe IV est ainsi formée sur la surface du substrat. On chauffe le substrat de verre ainsi traité préalablement, à savoir revêtu d'une couche de la composition principalement composée de chlorures d'éléments du groupe IV, on met la surface de ce substrat, au moins celle revêtus de la couche de la composition principalement composée de chlorures du groupe IVa en contact avec un composé d'étain, et enfin, on dépose par pyrolyse une couche d'étain.

La couche d'oxyde d'étain déposée ainsi sur la sous-couche de la composition principalement composée de chlorures du groupe IV, elle-même déposée sur la surface du substrat de verre a une meilleure conductivité que celle d'oxyde d'étain déposé directement sur la surface du substrat en verre, dans les mêmes conditions.

Il semblerait que la croissance des cristaux de la couche polycristalline d'oxyde d'étain déposée au-dessus de la sous-couche de la composition principalement composée de chlorures du groupe IVa soit influencée par cette sous-couche. On pense que la mobilité des porteurs de charges, qui est à l'origine de la conductivité de la couche d'oxyde d'étain est améliorée par cette sous-couche.

L'invention sera décrite plus en détail à l'aide d'exemples et en référence à la figure unique jointe qui représente la variation de la conductivité des couches d'oxyde d'étain en fonction de la concentration en $TiCl_4$ des solutions des prétraitements.


## EXEMPLE 1

Après avoir mouillé la surface des substrats en verre silicosodo-calcique revêtue d'une couche de $SiO_2$ d'une épaisseur d'environ 1200 Angstroems, avec des solutions aqueuses de chlorures de différents métaux du groupe IV, on évapore le solvant par séchage à l'air chaud de façon à former des sous-couches principalement composées de chlorures des différents métaux. Ensuite, on chauffe ces substrats à 550°C et on met leur surface ainsi traitée en contact avec un mélange de gaz comprenant du monobutyl, trichlorure d'étain, 1,1-difluoroéthane, de la vapeur d'eau, de l'oxygène et de l'azote. Ainsi, on dépose une couche d'oxyde d'étain d'une épaisseur d'environ 4500 Angstroems sur la surface des substrats.

Au tableau 1 disposé en fin de description, on indique la conductivité et la résistivité des couches d'oxyde d'étain ainsi formées. Egalement au tableau 1, on indique la conductivité des couches d'oxyde d'étain déposées directement sur la surface des substrats non prétraités, le dépôt par pyrolyse de la couche d'étain se faisant dans les mêmes conditions.

D'après le tableau 1, il est clair que les couches d'oxyde d'étain déposées sur la surface des substrats traités avec la solution aqueuse de chlorure de titane, celle de chlorure de zirconium et celle de chlorure d'hafnium en tant que solutions de traitement ont une excellente conductivité en comparaison avec le cas

3

où on n'a pas traité les substrats ou avec le cas où les chlorures sont des chlorures de métaux n'appartenant pas au groupe IV. Par prétraitement avec un chlorure du groupe IV, le gain de conductivité est au moins de 10 à 20%.

## EXEMPLE 2

Comme solution de traitement, on prépare des solutions aqueuses de chlorure de titane à différentes concentrations, on trempe dans ces solutions de traitement, des substrats de verre silico-sodo-calcique revêtus d'une couche de $SiO_2$ d'une épaisseur d'environ 1000 Angstroems, on sèche à l'air chaud pour évaporer le solvant. Ensuite, après avoir chauffé ces substrats à 550°C, on dépose une couche d'oxyde d'étain d'une épaisseur de 2500 Angstroems selon la méthode de l'exemple 1.

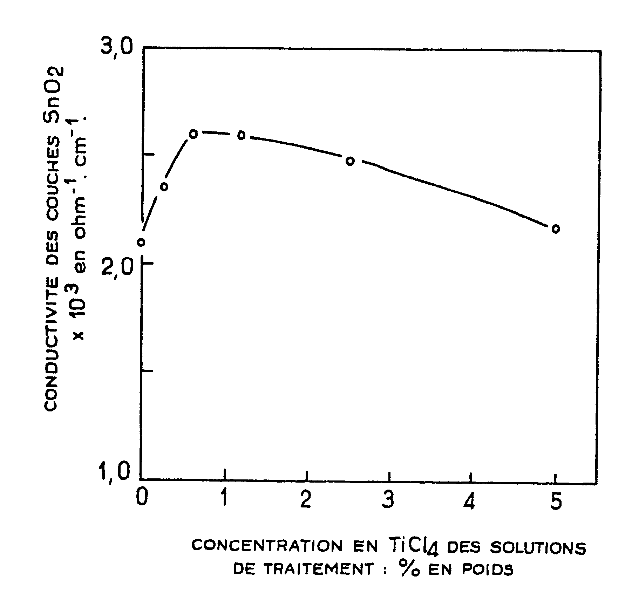

A la figure 1, on a indiqué en abscisse la concentration des solutions de $TiCl_4$ et en abscisse la conductivité des couches d'oxyde d'étain déposées sur la surface des substrats traités avec ces solutions ayant différentes concentrations.

D'après la figure 1, il est clair que les couches d'oxyde d'étain déposées sur la surface des substrats traités avec une solution de chlorure de titane d'une concentration allant jusqu'à 3% ont une meilleure conductivité que celles déposées dans les mêmes conditions sur la surface des mêmes substrats non-traités. Le gain de conductivité est déjà nettement appréciable à partir d'une concentration de la solution de prétraitement de l'ordre de 0.3%. Et quand on utilise une solution d'une concentration de 0.6 à 1.2% on peut obtenir une couche d'oxyde d'étain d'une conductivité plus élevée d'environ 20% par rapport à une même couche déposée sur un substrat non prétraité.

## EXEMPLE 3

Comme solution de traitement, on prépare une solution d'éthanol à 0.5% de chlorure de zirconium et on trempe dans cette solution des substrats de verre silico-sodo-calcique revêtus d'une couche de $SiO_2$ d'une épaisseur d'environ 1000 Angstroems. Après cela, on évapore l'éthanol par séchage à l'air chaud. Ensuite, on chauffe les substrats à 550°C, puis on dépose selon la méthode de l'exemple 1, une couche d'oxyde d'étain d'une épaisseur de 2500 Angstroems sur la surface des substrats traités.

Au tableau 2, on a indiqué les caractéristiques électriques des couches d'oxyde d'étain obtenues. Egalement, au tableau 2, on a indiqué les caractéristiques électriques des couches d'oxyde d'étain déposées selon la méthode classique dans les mêmes conditions sur les mêmes substrats non-traités.

D'après le tableau 2 disposé en fin de description, on peut comprendre que selon la méthode de cette invention, il est possible d'obtenir une couche d'oxyde d'étain très conductrice surtout du fait de la très haute mobilité des porteurs de charges en employant une solution de prétraitement avec l'éthanol comme solvant.

## EXEMPLE 4

On prépare, comme solution de traitement, une solution d'éthanol à 1.0% de chlorure de zirconium et on la pulvérise au moyen d'un pistolet sur la surface des substrats en verre silico-sodo-calcique chauffés à environ 150°C. Le solvant de la solution de traitement pulvérisée s'avapore immédiatement du fait de la chaleur des substrats. Ainsi, une couche de la composition principalement composée de chlorure de zirconium est formée sur la surface des substrats. Ensuite, on chauffe les substrats à 600°C et on met leur surface en contact avec une solution de dibutyl diacétate d'étain et d'acide trifluoroacétique dans l'éthanol, en pulvérisant ladite solution au moyen d'un pistolet. Ainsi, on dépose une couche d'oxyde d'étain d'une épaisseur de 2300 Angstroems.

Pour faire des comparaisons, on dépose une couche d'oxyde d'étain directement sur un substrat de verre silico-sodo-calcique chauffé à 600°C.

Au tableau 3, disposé en fin de description, on a indiqué la conductivité de chaque couche d'oxyde d'étain. D'après le tableau 3, il est clair que l'on peut obtenir des couches d'oxyde d'étain ayant une meilleure conductivité selon la méthode de cette invention.

## EXEMPLE 5

Comme solution de traitement, on prépare une solution à 0.1% de chlorure de zirconium et on l'applique sur la surface d'un substrat en verre au silicate de bore. Après cela, on sèche pour évaporer le solvant. Puis, on chauffe ce substrat à 550°C et on dépose sur la surface ainsi traitée, une couche d'oxyde d'étain d'une épaisseur de 4800 Angstroems selon la méthode indiquée à l'exemple 1.

Séparément, on chauffe à 550°C un autre substrat de verre au silicate de bore, non-traité préalablement, et on dépose une couche d'oxyde d'étain dans les mêmes conditions.

Au tableau 4, on indique les caractéristiques électriques de chaque couche d'oxyde d'étain. Au tableau 4, la conductivité de la couche d'oxyde d'étain selon la méthode classique, donc sans prétraitement est égale à $3.0 \times 10^3$ Ohms$^{-1}$cm$^{-1}$. Mais selon cette invention, c'est-à-dire avec prétraitement, on peut obtenir une couche d'oxyde d'étain plus conductrice et la conductivité atteint $3.6 \times 10^3$ Ohms$^{-1}$cm$^{-1}$. Dans ce cas, la mobilité des porteurs est plus élevée que selon la méthode classique. Les couches d'étain déposées selon la méthode de cette invention ont une bonne conductivité. Par exemple, la conductivité peut atteindre $3.6 \times 10^3$ Ohms$^{-1}$cm$^{-1}$. Egalement, elles ont une bonne mobilité des porteurs.

La méthode de dépôt de la couche d'oxyde d'étain faisant l'objet de cette invention consiste à effectuer un traitement préalable simple sur la surface des substrats avant de déposer une couche d'étain selon les méthodes classiques de dépôt de la couche d'oxyde d'étain par pyrolyse telles que la méthode de pulvérisation de liquide, la méthode de projection de poudre ou la méthode CVD. De ce fait, on peut utiliser cette invention pour des applications techniques très étendues de la couche d'oxyde d'étain pyrolysée sur la surface des substrats en verre. Cette invention est très utile pour améliorer la conductivité de la couche d'oxyde d'étain conventionnelle.

En outre, pour mettre les substrats en verre en contact avec la solution de chlorures d'éléments du groupe IVa, de nombreuses techniques sont utilisables.

## TABLEAU 1

Conductivité et résistivité de couches de $SnO_2$ d'un épaisseur de 450nm (4500 Å) déposées sur un substrat en verre revêtu d'une couche de $SiO_2$

---------------------------------------------------------

| Caractéristiques : Solution de traitement | | Conductivité X $10^3$ | Résistivité X $10^{-4}$ | Remarques |
|---|---|---|---|---|
| Chlorure de métal (concentration : % en poids) | | en ohm-1.cm-1 | en ohm.cm | |
| TiCl₄ | (2.5) | 2.6 | 3.8 | méthode de cette invention |
| TiCl₄ | (1.2) | 2.8 | 3.6 | " |
| ZrCl₄ | (2.5) | 2.7 | 3.7 | " |
| ZrCl₄ | (1.0) | 2.9 | 3.5 | " |
| HfCl₄ | (1.0) | 2.8 | 3.6 | " |
| NaCl | (5.0) | 1.5 | 6.5 | Ex. comparatif |
| NaCl | (2.5) | 2.0 | 5.0 | " |
| ZnCl₂ | (5.0) | 1.6 | 6.1 | " |
| ZnCl₂ | (2.5) | 2.1 | 4.7 | " |
| SnCl₂ | (0.1) | 2.1 | 4.8 | " |
| PdCl₂ | (0.1) | 2.0 | 5.0 | " |
| AlCl₃.6H₂O | (5.0) | 2.4 | 4.2 | " |
| InCl₃ | (5.0) | 2.2 | 4.5 | " |
| SbCl₃ | (1.0) | 2.4 | 4.2 | " |
| SnCl₄.5H₂O | (5.0) | 1.9 | 5.4 | " |
| Sans traitement par solution de chlorure | | 2.4 | 4.2 | Méthode classique |

## TABLEAU 2

Caractéristiques électriques des couches $SnO_2$

de 2500 Angstroems d'épaisseur

| | Solution de traitement | Conductivité $X\ 10^3$ en $Ohm^{-1}.cm^{-1}$ | Mobilité des porteurs en $cm^2V^{-1}S^{-1}$ | Densité en porteurs $X10^{20}$ par $cm^3$ |
|---|---|---|---|---|
| Méthode de traitement selon cette invention | Solution d'éthanol à 0.5 % en poids de $ZrCl_4$ | 2.6 | 24.6 | 6.6 |
| Méthode classique sans pré-traitement | sans trai-tement | 2.1 | 19.2 | 6.8 |

## TABLEAU 3

Conductivité et résistivité des couches $SnO_2$

de 2300 Angstroems d'épaisseur

| | Solution de trai-tement préalable des substrats | Conductivité $X\ 10^3$ en $ohm^{-1}.cm^{-1}$ | Résistivité $X10^{-4}$ $ohm.cm$ |
|---|---|---|---|
| Méthode de cette invention | Solution d'étha-nol à 1.0 % en poids de $ZrCl_4$ | 1.4 | 7.4 |
| Méthode classi-que | sans traitement | 1.2 | 8.5 |

## TABLEAU 4

### Caractéristiques électriques des couches SnO$_2$
### de 4800 Angstroems d'épaisseur

| | : Solution de traitement préalable des substrats | :Conductivité X 10$^3$ en Ohm$^{-1}$.cm$^{-1}$: | :Mobilité en cm$^2$V$^{-1}$S$^{-1}$ | :Densité en porteurs X10$^{20}$ par cm$^3$ |
|---|---|---|---|---|
| Méthode de traitement selon cette invention | : Solution aqueuse à 1.0 % en poids de ZrCl$_4$ | : 3.6 | : 32.7 | : 6.9 |
| Méthode classique | : sans trai- tement | : 3.0 | : 27.2 | : 6.9 |

## Revendications

1. Procédé pour former une couche d'oxyde d'étain sur un substrat en verre, consistant à chauffer ledit substrat à une température élevée et à mettre au moins un composé de l'étain au contact du verre chaud pour obtenir la décomposition thermique et l'oxydation du composé de l'étain et la formation dudit oxyde d'étain, caractérisé en ce que, préalablement à la formation de la couche d'oxyde d'étain, on met le substrat en verre au contact d'une solution d'au moins un chlorure de titane, de zirconium et d'hafnium pour former une précouche de composition principalement composée du et/ou des chlorures de ces métaux.

2. Procédé conforme à la revendication 1, caractérisé en ce que la couche d'oxyde d'étain est obtenue par pyrolyse de composés de l'étain sous forme de solutions, poudre ou gaz.

3. Procédé conforme à l'une des revendications 1 et 2, caractérisé en ce que la précouche composée principalement d'un ou plusieurs chlorures de titane, de zirconium et d'hafnium est obtenue par trempe du support dans une solution du ou des chlorures ou par pulvérisation d'une solution du ou des chlorures, puis séchage.

4. Produit formé d'un support en verre et d'une couche mince d'oxyde d'étain obtenue par décomposition thermique et oxydation d'un composé de l'étain au contact du substrat chauffé à température élevée, caractérisé en ce qu'il comprend une précouche composée principalement d'un ou plusieurs chlorures de titane, de zirconium et d'hafnium.

## Claims

1. Process for forming a film of tin oxide on a glass substrate, consisting of heating said substrate to a high temperature and bringing at least one tin compound into contact with the hot glass to cause the thermal decomposition and oxidation of the tin compound and the forming of said tin oxide, characterized in that, before the forming of the film of tin oxide, the glass substrate is brought into contact with a solution of at least one chloride of titanium, of zirconium and of hafnium, to form an underlying layer having a composition principally composed of the chloride and/or chlorides of these metals.

2. Process according to Claim 1, characterized in that the tin oxide form is obtained by pyrolysis of tin compounds in the form of solutions, powder or gas.

3. Process according to one of Claims 1 and 2, characterized in that the underlying layer composed principally of one or more chlorides of titanium, zirconium and hafnium is produced by immersing the support in a solution of the chloride or chlorides or by sputtering a solution of the chloride or chlorides, then drying.

4. Product formed of a glass support and a thin film of tin oxide produced by thermal decomposition and oxidation of a tin compound in contact with the substrate heated to high temperature, characterized in that the product comprises an underlying layer composed principally of one or more chlorides of titanium, zirconium and hafnium.

**Patentansprüche**

1. Verfahren zur Bildung einer Zinnoxidschicht auf einem Glassubstrat, das aus dem Erhitzen des Substrats auf eine erhöhte Temperatur und dem Inberührungsbringen des heißen Glases mit wenigstens einer Zinnverbindung unter Erhalt einer thermischen Zersetzung und Oxidation der Zinnverbindung und Bildung des Zinnoxids besteht, dadurch gekennzeichnet, daß vor der Bildung der Zinnoxidschicht das Glassubstrat mit einer Lösung aus wenigstens einem Chlorid von Titan, Zirkon und Hafnium zur Bildung einer Grundierung mit einer hauptsächlich aus einem oder mehreren Chloriden dieser Metalle bestehenden Zusammensetzung in Berührung gebracht wird.

2. Verfahren nach Anspruch 1, dadurch gekennzeichnet, daß die Zinnoxidschicht durch Pyrolyse der Zinnverbindungen in Form von Lösungen, Pulver oder Gas erhalten wird.

3. Verfahren nach einem der Ansprüche 1 und 2, dadurch gekennzeichnet, daß die hauptsächlich aus einer oder mehreren Chloriden von Titan, Zirkon und Hafnium zusammengesetzte Grundierung durch Eintauchen des Trägers in eine Lösung aus dem oder den Chloriden oder durch Zerstäubung einer Lösung des oder der Chloride und anschließende Trocknung erhalten wird.

4. Aus einem Glasträger und einer dünnen Zinnoxidschicht gebildetes Produkt, erhalten durch thermische Zersetzung und Oxidation einer Zinnverbindung in Kontakt mit dem auf eine erhöhte Temperatur erhitzten Substrat, dadurch gekennzeichnet, daß es eine hauptsächlich aus einem oder mehreren Chloriden von Titan, Zirkon und Hafnium gebildete Grundierung umfaßt.

CONCENTRATION EN TiCl$_4$ DES SOLUTIONS
DE TRAITEMENT : % EN POIDS